Europäisches Patentamt

European Patent Office

Office européen des brevets

(11) Veröffentlichungsnummer: **0 392 574**

**A2**

## (12) EUROPÄISCHE PATENTANMELDUNG

(21) Anmeldenummer: **90200446.4**

(22) Anmeldetag: **26.02.90**

(51) Int. Cl.5: **G01N 24/00**

(30) Priorität: **04.03.89 DE 3906978**

(43) Veröffentlichungstag der Anmeldung:
**17.10.90 Patentblatt 90/42**

(84) Benannte Vertragsstaaten:
**DE FR GB**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB**

(72) Erfinder: **McKinnon, Graeme, Dr.**
**Höschgasse 62**
**CH-8008 Zürich(CH)**
Erfinder: **Bösiger, Peter, Dr. Priv.-Doz.**
**Rebbergstrasse 73**
**CH-5400 Ennetbaden(CH)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) **Verfahren zur lokalisierten Kernresonanzspektroskopie und Anordnung zur Durchführung des Verfahrens.**

(57) Die Erfindung betrifft ein Verfahren zur lokalisierten Kernresonanzspektroskopie, bei dem in Anwesenheit eines stationären homogenen Magnetfeldes eine Anzahl von Sequenzen auf einen Untersuchungsbereich einwirkt, von denen jede drei im gleichen zeitlichen Abstand aufeinanderfolgende 180°-Hochfrequenzimpulse umfaßt, denen wenigstens ein Hochfrequenzimpuls vorausgeht, der eine Transversalmagnetisierung hervorruft sowie eine Anordnung zur Durchführung des Verfahrens. Dabei kann eine von der J-Kopplung unabhängige Echozeit dadurch erreicht werden, daß der erste und der dritte der drei 180°-Hochfrequenzimpulse sowie der vorausgehende Hochfrequenzimpuls schichtselektive Impulse sind, die drei Schichten anregen, daß der zweite 180°-Hochfrequenzimpuls ein frequenzselektiver Puls ist, der so gestaltet ist, daß er nur eine der beiden miteinander gekoppelten Komponenten eines Stoffes anregt, und daß das Kernresonanzsignal aus dem Schnittberich der drei Schichten zur Ermittlung seines Spektrums verarbeitet wird.

## Verfahren zur lokalisierten Kernresonanzspektroskopie und Anordnung zur Durchführung des Verfahrens

Die Erfindung betrifft ein Verfahren zur lokalisierten Kernresonanzspektroskopie, bei dem in Anwesentheit eines stationären homogenen Magnetfeldes eine Anzahl von Sequenzen auf einen Untersuchungsbereich einwirkt, von denen jede drei im gleichen zeitlichen Abstand aufeinanderfolgende 180°-Hochfrequequenzimpulse umfaßt, denen wenigstens ein Hochfrequenzimpuls vorausgeht, der eine Transversalmagnetisierung hervorruft.

Als "lokalisierte Kernresonanzspektroskopie" wird hierbei und im folgenden die Ermittlung des Spektrums von Kernresonanzsignalen aus einem Teilbereich eines Untersuchungsgebietes verstanden, das den Teilbereich einschließt, beispielsweise aus einem Teil des Kopfes eines Patienten. Bei derartigen spektroskopischen Untersuchungen geht es oft um den Nachweis von Stoffen, zwischen deren Molekülgruppen eine J-Kopplung besteht. Beispielsweise besteht zwischen der $CH_3$-Gruppe und der CH-Gruppe von Milchsäure eine J-Kopplung. Diese J-Kopplung bewirkt, daß die einzelnen Molekülgruppen im Kernresonanzspektrum nicht als Linien erscheinen, sondern als Doppellinien, deren Frequenzabstand der Stärke J der Kopplung entspricht.

In der europäischen Patentanmeldung 322006 ist bereits ein Verfahren beschrieben, das sich zur lokalisierten Spektroskopie, beispielsweise von Milchsäure,eignet. Bei diesem Verfahren umfaßt jede Sequenz zur Anregung der Kernmagnetisierung ein 90°-Impuls, dem im gleichen zeitlichen Abstand ein 180°-Impuls und ein weiterer 90°-Impuls folgen. Die beiden 90°-Impulse sind dabei frequenzselektiv. Diesen drei Hochfrequenzimpulsen folgen innerhalb einer Sequenz drei schichtselektive 180°-Hochfrequenzimpulse, die die Lokalisation bewirken. Bei einem Verfahren dieser Art muß die Echozeit, das ist der Zeitraum zwischen dem ersten Hochfrequenzimpuls und dem Auftreten des zu verarbeitenden Kernresonanzsignals, dem Wert 1/J bzw. einem Vielfachen davon entsprechen; andernfalls löschen sich die Signalanteile ganz oder teilweise aus, die einer Doppellinie zugeordnet sind. Da J bei vielen der genannten Stoffe in der Größenordnung von 7 Hz liegt, bedeutet dies, daß die Echozeit etwa bei 140 ms liegen muß.

Einerseits ist eine solche Zeit für Stoffe, die eine kurze Querrelaxationszeit $T_2$ aufweisen, zu lang. Andererseits kann es aber auch erforderlich sein, die Echozeit noch größer zu wählen, um bis zur Erfassung des Kernresonanzsignals die Wirbelströme abklingen zu lassen, die durch das Ein- und Ausschalten der zur Lokalisation erforderlichen magnetischen Gradientenfelder erzeugt werden.

Aufgabe der Erfindung ist es daher, ein Verfahren der eingangs genannten Art so auszugestalten, daß die Echozeit unabhängig von der Stärke der J-Kopplung gewählt werden kann. Diese Aufgabe wird erfindungsgemäß dadurch gelöst, daß der erste und der dritte der drei 180°-Hochfrequenzimpulse sowie der vorausgehende Hochfrequenzimpuls schichtselektive Impulse sind, die drei Schichten anregen, daß der zweite 180°-Hochfrequenzimpuls ein frequenzselektiver Puls ist, der so gestaltet ist, daß er nur eine der beiden miteinander gekoppelten Komponenten eines Stoffes anregt, und daß das Kernresonanzsignal aus dem Schnittbereich der drei Schichten zur Ermittlung seines Spektrums verarbeitet wird.

Bei der Erfindung wird wenigstens ein erster Hochfrequenzimpuls erzeugt, der schichtselektiv ist und in der Schicht eine transversale Magnetisierung hervorruft, vorzugsweise ein 90°-Hochfrequenzimpuls. Diesem folgen drei 180°-Hochfrequenzimpulse, von denen der erste und der dritte schichtselektiv sind, während der zweite frequenzselektiv ist und nur eine der beiden Komponenten des nachzuweisenden Stoffes anregt.

Für die eine Komponente im Schnittbereich der drei Schichten wirkt der frequenzselektive 180°-Hochfrequenzimpuls refokussierend, so daß sich die Wirkung der J-Kopplung auf die mit dieser Komponente verknüpfte Kernmagnetisierung zu einem Zeitpunkt aufhebt, dessen zeitlicher Abstand vom frequenzselektiven Impuls dessen Abstand von dem vorausgehenden schichtselektiven Hochfrequenzimpuls entspricht. Deshalb muß das Kernresonanzsignal zu diesem Zeitpunkt bzw. um diesen Zeitpunkt herum erfaßt werden. Die hieraus resultierende Echozeit kann durch geeignete Wahl des zeitlichen Abstandes zwischen dem vorausgehenden Impuls und den drei 180°-Hochfrequenzimpuls den Erfordernissen angepaßt werden; sie ist von der J-Kopplung unabhängig.

Der frequenzselektive 180°-Hochfrequenzimpuls beeinflußt die andere Komponente des Stoffes nicht. Diese Komponente hat daher keinen Einfluß auf das im Schnittbereich der drei Schichten erzeugte Kernresonanzsignal.

Die Erfindung wird nachstehend anhand der Zeichnungen näher erläutert. Es zeigen

Fig. 1 ein Gerät, mit dem das erfindungsgemäße Verfahren durchführbar ist,

Fig. 2 ein Blockschaltbild eines solchen Gerätes,

Fig. 3 die Lage der Spektralkomponenten von Wasser und Milchsäure,

Fig. 4 den zeitlichen Verlauf einer Sequenz.

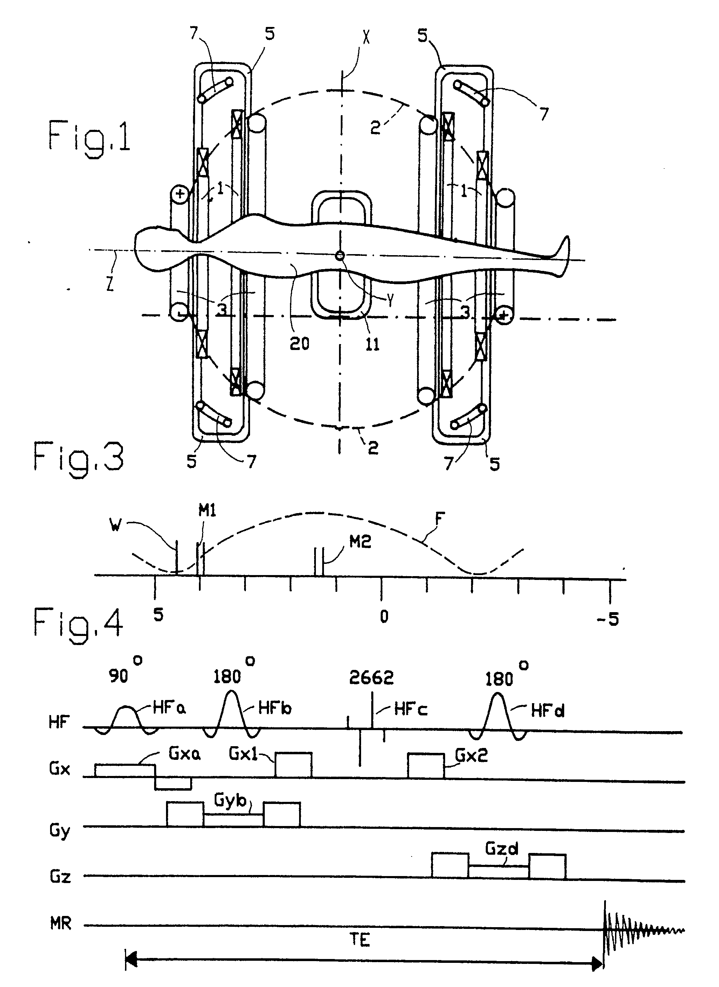

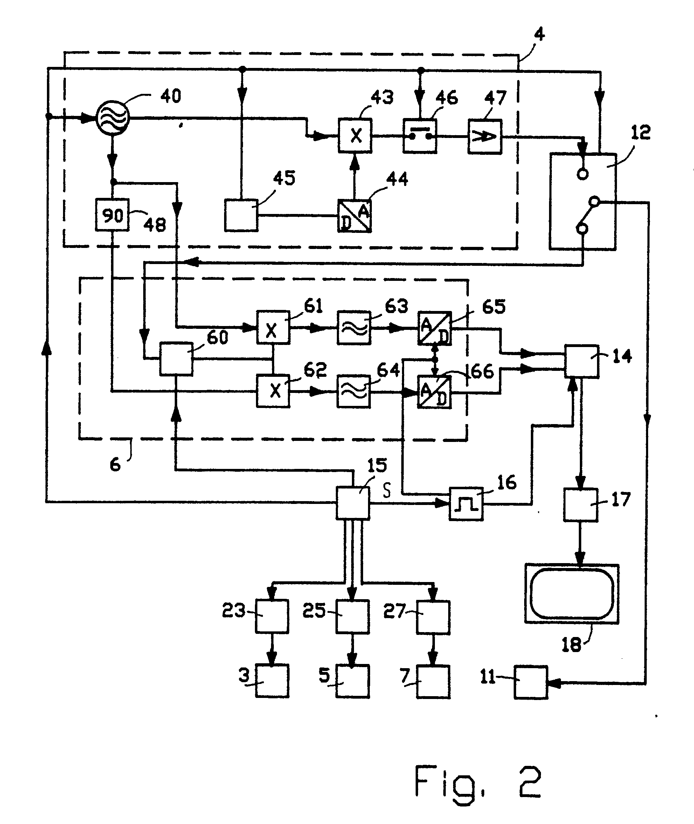

Das in Fig. 1 schematisch dargestellte Kernspinuntersuchungsgerät enthält eine aus vier Spulen 1 bestehende Anordnung zur Erzeugung eines homogenen stationären Magnetfeldes, das in der Größenordnung von einigen zehntel Tesla bis einigen Tesla liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die mit den Spulen 7 identisch sein können, die jedoch diesen gegenüber um 90° räumlich versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder Gz, Gy, Gx symmetrisch zur Kugeloberfläche 2 angeordnet ist, ist die Feldstärke im Kugelzentrum, das gleichzeitig den Koordinatenursprung des erwähnten kartesischen x-y-z-Koordinatensystems bildet, nur durch das stationäre homogene Magnetfeld der Spulenanordnung 1 bestimmt.

Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes, verlaufendes hochfrequentes Magnetfeld erzeugt wird. Der Hochfrequenzspule wird während jedes Hochfrequenzimpulses ein hochfrequenter, im allgemeinen amplitudenmodulierter Strom von einem Hochfrequenzgenerator zugeführt. Im Anschluß an die drei Hochfrequenzimpulse jeder Teilsequenz dient die Hochfrequenzspule 11 zum Empfangen des im Untersuchungsbereich erzeugten Kernresonanzsignals. Stattdessen kann aber auch eine gesonderte Hochfrequenzempfangsspule verwendet werden.

Fig. 2 zeigt ein vereinfachtes Blockschaltbild dieses Kernspinuntersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz von einer Steuereinheit 15 digital steuerbaren Hochfrequenzoszillator 40, der Schwingungen mit einer Frequenz im Bereich der Larmorfrequenz der anzuregenden Atomkerne bei der von den Spulen 1 erzeugten Feldstärke aufweist. Die Larmorfrequenz f berechnet sich bekanntlich nach der Beziehung $f = cB$, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Ausgang mit einem digitalen Speicher 45 verbunden ist. Aus dem Speicher wird - gesteuert durch die Steuereinrichtung 15 - eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenzleistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem das jeweils in der Hochfrequenzspule 11 induzierte stimulierte Echosignal zugeführt wird, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils einen dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90°-Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadraturdemodulator bildenden Schaltung 61..64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können. Die im Speicher 14 gespeicherten Datenworte bzw. Abtastwerte werden einem Rechner 17 zugeführt, der daraus durch eine diskrete Fouriertransformation die Spektralverteilung der Kernmagnetisierung ermittelt und die ermittelte Verteilung an einer geeigneten Wiedergabeeinheit, z.B. einem Monitor 18, ausgibt.

Die Gradientenspulenanordnungen 3, 5 und 7 werden von Stromgeneratoren 23, 25 und 27 jeweils mit einem Strom versorgt, dessen zeitlicher Verlauf durch die Steuereinheit 15 steuerbar ist.

Fig. 3 zeigt die Lage der für den klinischen Nachweis von Milchsäure wesentlichen Komponenten auf einer Frequenzskala, die die Abweichung von der Larmorfrequenz von TMS (Tetramethylsilan) angibt (in ppm). Die Larmorfrequenz von TMS liegt somit definitionsgemäß bei Null, während die Larmorfrequenz W von Wasser bei 4,7 ppm liegt. Die Doppellinie M2 der $CH_3$-Gruppe der Milchsäure (Lactat) liegt bei 1,3 ppm, während die Doppellinie derjenigen in Milchsäure enthaltenden CH-Gruppe, die damit über eine J-Kopplung in Wechselwirkung tritt, bei 4,1 ppm liegt.

In Fig. 4 ist in der ersten Zeile die zeitliche Lage der Hochfrequenzimpulse, in den Zeilen 2-4 die zeitliche Lage der magnetischen Gradientenfelder Gx, Gy und Gz und in der fünften Zeile das Kernresonanzsignal dargestellt, das zur Ermittlung des Spektrum herangezogen wird.

Die Sequenz beginnt mit einem 90°-Hochfrequenzimpuls HFa, der von einem magnetischen Gradientenfeld Gxa begleitet wird, dessen Gradient in x-Richtung verläuft. Der Hochfrequenzimpuls HFa ist also ein schichtselektiver Hochfrequenzimpuls, durch den in einer Schicht, deren Lage von der Mittenfrequenz des Hochfrequenzimpulses HFa bestimmt ist und deren Dicke von dessen Bandbreite sowie von der Größe des Gradienten des magnetischen Gradientenfeldes bestimmt wird, eine transversale Magnetisierung erzeugt wird.

Dem Hochfrequenzimpuls HFa folgt ein 180°-Hochfrequenzimpuls HFb, der von einem magnetischen Gradientenfeld Gy mit in y-Richtung verlaufendem Gradienten begleitet wird. Dieser Hochfrequenzimpuls wirkt somit auf eine Schicht, die zu der y-Achse und der durch den ersten Hochfrequenzimpuls angeregten Schicht senkrecht steht. Er invertiert die Kernmagnetisierung innerhalb dieser Schicht. Das ihn begleitende magnetische Gradientenfeld Gyb bewirkt außerdem, daß die Kernmagnetisierung in der ersten Schicht -soweit sie nicht gleichzeitig in der zweiten Schicht liegt, dephasiert wird.

Anschließend folgt ein 180°-Hochfrequenzimpuls HFC, der als frequenzselektiver Impuls gestaltet ist und nur eine der beiden Komponenten M1, M2 der Milchsäure, vorzugsweise die durch die $CH_3$-Gruppe hervorgerufene Milchsäurekomponente M2 anregt, während er die andere Komponente nicht beeinflußt. Ein derartiger Hochfrequenzimpuls läßt sich mit Hilfe eines sogenannten binomialen Hochfrequenzimpulses realisieren, beispielsweise eines 2662-Hochfrequenzimpulses.

Ein binomialer Hochfrequenzimpuls besteht bekanntlich aus einer folge von Teilpulsen, deren zugeordneter Flipwinkel (das ist der Winkel, um den die Kernmagnetisierung durch einen solchen Puls aus der Ruhelage gekippt wird) im gleichen Verhältnis zueinander stehen wie die Binomialkoeffizienten, wobei jeder Teilpuls die Kernmagnetisierung mit gleichem oder entgegengesetztem Drehsinn dreht wie der vorausgehende Teilpuls. Die Mittenfrequenz der Teilpulse muß der Larmorfrequenz der Milchsäurekomponente M2 oder M1 entsprechen - je nachdem, ob die aufeinanderfolgenden Teilpulse die gleiche oder die entgegengesetzte Phasenlage haben. Der zeitliche Abstand zwischen zwei Teilpulsen muß so gewählt sein, daß die Phasenlage der nicht anzuregenden Komponente (M1) sich von Teilpuls zu Teilpuls gerade um 180° (oder ein ungeradzahliges Vielfaches davon) ändert. Dazu muß der zeitliche Abstand zwischen zwei Teilpulsen jeweils der Hälfte des Kehrwertes der Frequenzdifferenz zwischen den beiden Komponenten M1 und M2 entsprechen.

An sich beträgt diese Frequenzdifferenz nur etwa 180 Hz (wenn die von den Spulen 1 erzeugte Induktionsflußdichte 1,5 Tesla beträgt), doch ist es zweckmäßig, die Frequenzdifferenz zwischen M2 und der Larmorfrequenz von an Wasser gebundenen Protonen anzusetzen (etwa 217 Hz), weil dadurch eine bessere Unterdrückung der im Signal enthaltenen Wasserkomponente und immer noch eine ausreichende Unterdrückung der Komponente M1 erreicht wird. Dies entspricht einem zeitlichen Abstand, der Teilpulse von ca. 2,3 ms.

Nach dem frequenzselektiven Hochfrequenzimpuls Hfc folgt ein schichtselektiver 180°-Hochfrequenzimpuls HFd, dessen Abstand von dem Hochfrequenzimpuls HFc genauso groß ist wie der Abstand zwischen HFb und HFc (jeweils von der Mitte dieser Impulse aus gerechnet). Während dieses Hochfrequenzimpulses ist der Stromgenerator 23 eingeschaltet, so daß die Spulen 3 ein magnetisches Gradientenfeld Gzd mit in z-Richtung verlaufendem Gradienten erzeugen. Dadurch wird die Kernmagnetisierung innerhalb einer Schicht beeinflußt, die senkrecht zur z-Achse und senkrecht zu den durch die Hochfrequenzimpulse HFa und HFb beeinflußten Schichten verläuft. Anschließend existiert nur im Schnittbereich der drei genannten Schichten eine transversale Kernmagnetisierung. Die Wirkung des frequenzselektiven Hochfrequenzimpulses HFc in Verbindung mit den übrigen Hochfrequenzimpulsen auf die Kernmagnetisierung im Schnittbereich hängt von der Larmorfrequenz der jeweiligen Komponenten ab.

Die Kernmagnetisierung der im Schnittbereich enthaltenen $CH_3$-Gruppe M2 von Milchsäure wird durch den Hochfrequenzimpuls HFC refokussiert. Das magnetische Gradientenfeld, dessen Gradient in x-Richtung verläuft, und das zwischen HFb und HFC (Gx1) sowie zwischen HFc und HFd eingeschaltet wird, derart, daß das zeitliche Integral über den Gradienten in beiden Intervallen gleich und der Hochfrequenzimpuls HFc genau in der Mitte liegt, beeinflußt diese Komponenten nicht. Somit wirken die drei Hochfrequenzimpulse HFb, HFc und HFd für die Komponente M2 im Schnittbereich der drei Schichten wie ein einziger 180°-Hochfrequenzimpuls, und das in Verbindung mit dem ersten Hochfrequenzimpuls HFa erzeugte Echosignal hat zu einem Zeitpunkt sein Maximum, dessen zeitlicher Abstand vom Impuls HFc, dessen zeitlichen Abstand vom Impuls HFa entspricht. Die Echozeit TE ist damit doppelt so groß wie der Abstand zwischen HFa und HFc und somit von der Stärke der J-Kopplung unabhängig. Sie kann daher den diagnostischen Erfordernissen angepaßt werden.

Die im Schnittbereich enthaltene Komponente M1 von Milchsäure sowie die Wasserkomponente "sehen" den frequenzselektiven Hochfrequenz HFC nicht. Die Kernmagnetisierung dieser Komponenten wird daher nicht fokussiert, so daß diese Komponenten keinen Beitrag zum Kernresonanzsignal (5. Zeile von Fig. 4) leisten. Der zweite Hochfrequenzimpuls Hfc wirkt somit wie ein (periodisches) Filter, dessen Kennlinie F in Fig. 3 gestrichelt angedeutet ist.

Nach dem Hochfrequenzimpuls HFb und nach dem Ausschalten aller magnetischer Gradientenfelder wird das Spektrometer auf Empfang geschaltet, beispielsweise, indem der Umschalter 12 in die in der Zeichnung dargestellte Stellung gebracht wird. Gleichzeitig gibt die Steuereinheit 15 den Taktgeber 16 frei, so daß das empfangene und in den Niederfrequenzbereich transponierte Kernresonanzsignal in eine Folge von digitalen Datenworten umgesetzt wird, die im Speicher 14 gespeichert werden. Da das Signal-Rausch-Verhältnis des sich bei einer einzigen Sequenz ergebenden Kernresonanzsignals unzureichend ist, wird die Sequenz -jeweils nach einer geeignet gewählten Repetitionszeit - periodisch wiederholt und die digitalisierten Kernresonanzsignale summiert, bis ein geeignetes Signal-Rausch-Verhältnis erreicht ist. Anschließendwird in der Einheit 17 aus der Summe der Kernresonanzsignale durch Fouriertransformation das Frequenzspektrum vermittelt.

Vorstehend wurde davon ausgegangen, daß den drei 180°-Hochfrequenzimpulsen HFb..HFd nur ein einziger Hochfrequenzimpuls (HFa) vorausgeht. Es können jedoch innerhalb einer Sequenz auch mehrere Hochfrequenzimpulse vorausgehen, von denen der letzte schichtselektiv sein muß und nicht frequenzselektiv sein darf; dieser letzte Impuls sollte die Kernmagnetisierung in der von ihm beeinflußten Schicht um 90° kippen.

## Ansprüche

1. Verfahren zur lokalisierten Kernresonanzspektroskopie, bei dem in Anwesenheit eines stationären homogenen Magnetfeldes eine Anzahl von Sequenzen auf einen Untersuchungsbereich einwirkt, von denen jede drei im gleichen zeitlichen Abstand aufeinanderfolgende 180°-Hochfrequenzimpulse umfaßt, denen wenigstens ein Hochfrequenzimpuls vorausgeht, der eine Transversalmagnetisierung hervorruft,
dadurch gekennzeichnet, daß der erste und der dritte der drei 180°-Hochfrequenzimpulse (HFb, HFd) sowie der vorausgehende Hochfrequenzimpulse (HFa) schichtselektive Impulse sind, die drei Schichten anregen, daß der zweite 180°-Hochfrequenzimpuls (HFc) ein frequenzselektiver Puls ist, der so gestaltet ist, daß er nur eine der beiden miteinander gekoppelten Komponenten eines Stoffes anregt, und daß das Kernresonanzsignal aus dem Schnittbereich der drei Schichten zur Ermittlung seines Spektrums verarbeitet wird.

2. Verfahren nach Anspruch 1,
dadurch gekennzeichnet, daß zum Nachweis von Milchsäure der zweite 180°-Hochfrequenzimpuls (HFc) so gestaltet ist, daß er die $CH_3$-Gruppe von Milchsäure anregt und die an Wasser gebundenen Protonen nicht anregt.

3. Verfahren nach Anspruch 1 oder 2,
dadurch gekennzeichnet, daß im Intervall zwischen dem ersten und dem zweiten sowie im Intervall zwischen dem zweiten und dem dritten 180°-Hochfrequenzimpuls ein magnetisches Gradientenfeld ein- und ausgeschaltet wird, das so gestaltet ist, daß das zeitliche Integral über den Gradienten dieses Feldes in beiden Intervallen gleich ist.

4. Vorrichtung zur Durchführung des Verfahrens nach Anspruch 1 mit Mitteln (1) zur Erzeugung eines homogenen stationären Magnetfeldes, mit einer Hochfrequenzspulenanordnung (11) zum Erzeugen von Hochfrequenzimpulsen und zum Aufnehmen der als Reaktion darauf im Untersuchungsbereich erzeugten Kernresonanzsignale, mit Gradientenspulen zur Erzeugung von magnetischen Gradientenfeldern mit in unterschiedlichen Richtungen verlaufendem Gradienten, einer Verarbeitungseinheit (17) zum Ableiten eines Spektrums aus den aufgenommenen Kernresonanzsignalen und mit einer Steuereinheit (15),

dadurch gekennzeichnet, daß die Steuereinheit mindestens eine Sequenz erzeugt, bei der auf einen ersten schichtselektiven Hochfrequenzimpuls (HFa drei 180°-Impulse (HFb..HFd) erfolgen, von denen der erste und der dritte schichtselektiv und der zweite frequenzselektiv ist.

Fig.1

Fig.3

Fig.4

Fig. 2